# EUROPEAN PATENT APPLICATION

(11) **EP 4 675 108 A1**
(43) Date of publication of application: **07.01.2026**
(21) Application number: 24901775.7
(22) Date of filing: 26.09.2024
(51) Int. Cl.: F04D 25/08

(54) **FAN ROTOR, HEAT DISSIPATION FAN AND ELECTRONIC DEVICE**

(30) Priority: 21.05.2024 CN 202410634079
(71) Applicant: Nanchang Huaqin Electronic Technology Co., Ltd., Nanchang, Jiangxi 330224 (CN)
(72) Inventor: YANG, Jialiang, Nanchang, Jiangxi 330224 (CN); LI, Chuansheng, Nanchang, Jiangxi 330224 (CN); YU, Binjun, Nanchang, Jiangxi 330224 (CN)
(74) Representative: Boult Wade Tennant LLP
(86) International application number: PCT/CN2024/121263
(87) International publication number: WO 2025/241369

(57) **Abstract**

Disclosed are a fan rotor, a cooling fan and an electronic device. The fan rotor includes a central shaft, a plurality of first blades, a plurality of second blades, and a fixing ring. The central shaft is provided with a first region and a second region alternately distributed along a circumferential direction at a periphery of the central shaft. The plurality of first blades are arranged around the central shaft in the first region, each having a first end connected to the central shaft. The plurality of second blades are arranged around the central shaft in the second region, each having a first end connected to the central shaft. The fixing ring is arranged around the central shaft, and connected to a second end of each of the plurality of first blades. The fan rotor, the cooling fan and the electronic device provided in the embodiments of the present application can improve the heat dissipation capability of the cooling fan.

## Description

The present application claims priority from Chinese patent application No. 202410634079.7, titled " FAN ROTOR, COOLING FAN AND ELECTRONIC DEVICE" filed with the China Patent Office on May 21, 2024, the entire contents of which are incorporated herein by reference.

### TECHNICAL FIELD

Embodiments of the present application relate to the technical field of electronic device heat dissipation, and particularly relate to a fan rotor, a cooling fan and an electronic device.

### BACKGROUND OF THE INVENTION

With the continuous development of the electronic technology, the manufacturing process of core devices in an electronic device is greatly improved. Meanwhile, various electronic devices gradually tend to be miniaturized. As a result, various heat-producing components in the electronic device tends to generate heat in a centralized manner, and as the heat is accumulated, normal operation of some components in the electronic device will be affected. Therefore, some heat dissipation means is desired for dissipating the heat generated by heat-producing components in an electronic device.

At present, air-cooled heat dissipation is still a widely applied heat dissipation form. In air-cooled heat dissipation, a cooling fan is used, which can increase the air circulation rate during operation, and timely transfer heat from a specific region to the outside. A heat dissipation capability of the cooling fan determines the operation performance of the electronic device. Therefore, how to improve the heat dissipation capability of the cooling fan is an important issue.

### SUMMARY OF THE INVENTION

An object of the implementations of the present application is to provide a fan rotor, a cooling fan and an electronic device which can improve the heat dissipation capability of the cooling fan.

To solve the above technical problem, an implementation of the present application provides a fan rotor including a central shaft, a plurality of first blades, a plurality of second blades, and a fixing ring. The central shaft is provided with a first region and a second region alternately distributed along a circumferential direction at a periphery of the central shaft. The plurality of first blades are arranged around the central shaft in the first region, each having a first end connected to the central shaft. The plurality of second blades are arranged around the central shaft in the second region, each having a first end connected to the central shaft. The fixing ring is arranged around the central shaft, and connected to a second end of each of the plurality of first blades.

An implementation of the present application further provides a cooling fan, including a housing, a fan stator, and the fan rotor as described above. The fan stator is disposed in the housing, and the fan rotor is rotatably connected to the fan stator.

An implementation of the present application further provides an electronic device, including the cooling fan as described above.

According to the fan rotor, the cooling fan and the electronic device provided in the implementations of the present application, the first blade and the second blade are both arranged in a hollowed-out region on one side of the blades. One of the first blade or the second blade has air suction characteristics, so that the air pressure, and thus the air inlet volume at the air inlet, can be increased. An air inlet region is reserved near the blades in the hollowed-out region on the one side of the blades, which can provide favorable conditions for air incoming from the air inlet of the cooling fan. With the blade having air suction characteristics incorporated in the hollowed-out region on the one side of the blades, an additional air suction effect is provided and the air pressure is increased on the basis of the air flow effect generated by the original blades. Therefore, the air inlet volume of the cooling fan is effectively increased, and the heat dissipation capability of the cooling fan is improved.

In some implementations, the fan rotor further includes a plurality of third blades arranged around the central shaft in the second region. Each of the third blades has a first end connected to the fixing ring, and a second end extending toward a corresponding second blade in the same region. In this manner, by providing the third blades in the region where the second blades are located, the action region of the blades can be increased, and the sweeping effect of the blades is ensured.

In some implementations, the plurality of second blades are arranged circularly in a direction opposite to the plurality of first blades. In this manner, by arranging the second blades circularly in a direction opposite to the first blades, a sufficient air inlet region with no obvious blocking can be reserved on a side of the second blades close to the central shaft, which can help to increase the air volume of the cooling fan.

In some implementations, more than one of the third blades are located in the same region, with lengths gradually increased or gradually decreased in the circumferential direction of the central shaft. In this manner, the third blades with variable lengths can sufficiently adapt to an outside space of the second blades to be fully extended.

In some implementations, the plurality of first blades are centrifugal blades, and the plurality of second blades are axial flow blades. In this manner, by providing different blades in different regions, the air flow guidance effects of different blades at different positions can be combined to improve the heat dissipation capability of the cooling fan.

In some implementations, second ends of the plurality of second blades extend to a position where the fixing ring is located to be connected to the fixing ring. In this manner, by connecting the second blades to the fixing ring, the connection stability of the blades as a whole can be ensured.

In some implementations, a projection of each second blade toward an adjacent first blade is located within edges of the first blade. In this manner, by receiving each second blade in the region between two adjacent first blades, the occupied space can be saved, and the volume can be reduced.

In some implementations, the plurality of second blades and the plurality of first blades are distributed in different planes, and in an axial direction of the central shaft, each of the second blades at least partially protrudes out of edges of the first blade. In this manner, by providing the second blades protruding out of the edges of the first blade, the effective area, and thus the air suction capacity, of the second blades can be increased.

### BRIEF DESCRIPTION OF THE DRAWINGS

One or more embodiments are illustrated through corresponding figures in the accompanying drawings, but such illustration does not constitute any limitation to the embodiments. Throughout the drawings, elements having like reference numerals represent like elements, and the drawings are not to be construed as limiting in scale unless otherwise specified.
FIG. 1 is a schematic structural diagram of a fan rotor for a centrifugal cooling fan in the existing art;
FIG. 2 is a schematic perspective view of a fan rotor for a cooling fan according to some embodiments of the present application;
FIG. 3 is a schematic front view of a fan rotor for a cooling fan according to some embodiments of the present application;
FIG. 4 is a schematic top view of a fan rotor for a cooling fan according to some embodiments of the present application;
FIG. 5 is a schematic top view of a fan rotor for a cooling fan according to some other embodiments of the present application;
FIG. 6 is a schematic perspective view of a fan rotor for a cooling fan according to some other embodiments of the present application;
FIG. 7 is a schematic perspective view of a fan rotor for a cooling fan according to some other embodiments of the present application;
FIG. 8 is a schematic top view of a fan rotor for a cooling fan according to some other embodiments of the present application;
FIG. 9 is a schematic top view of a fan rotor for a cooling fan according to some other embodiments of the present application;
FIG. 10 is a schematic perspective view of a fan rotor for a cooling fan according to some other embodiments of the present application;
FIG. 11 is a schematic top view of a fan rotor for a cooling fan according to some other embodiments of the present application;
FIG. 12 is a schematic perspective view of a centrifugal cooling fan in the existing art; and
FIG. 13 is a schematic perspective view of an axial flow fan in the existing art.

### DETAIL DESCRIPTION OF THE INVENTION

To make the objects, technical solutions and advantages of the embodiments of the present application clearer, implementations of the present application will be described in detail below with reference to the accompanying drawings. However, it will be appreciated by those of ordinary skill in the art that numerous technical details are set forth in various implementations of the present application to provide a better understanding of the present application. However, the technical solutions claimed in the present application can be implemented even without these technical details or based on various changes and modifications based on the following implementations. The following embodiments are divided for convenience of description, and should not constitute any limitation to the specific implementation of the present application, and the embodiments may be mutually incorporated and referred to without contradiction.

Unless otherwise defined, all technical and scientific terms used herein have the same meaning as commonly understood by one of ordinary skill in the art of the present application. The terminology used herein is for the purpose of describing particular embodiments only and is not intended to be limiting of the present application. The terms "include" and "comprise", as well as any variations thereof, used in the description and claims of the present application and the description of the figures above, are intended to cover a non-exclusive inclusion.

In the description of the embodiments of the present application, unless explicitly stated or defined otherwise, the terms "mounted", "connected", "coupled" and the like are to be construed broadly and encompass, for example, fixed connection, detachable connection, or integral connection; or mechanical or electrical connection; or direct connection, indirect connection via an intermedium, or internal communication or interaction between two elements. The specific meaning of the above terms in the embodiments of the present application will be understood by those of ordinary skill in the art as the case may be.

As electronic devices continue to be miniaturized, the demand for heat dissipation is also increasing. For example, various heat dissipation modes, such as air cooling and liquid cooling, have been designed for devices with large heat generation in electronic devices such as computers and laptops. In the air cooling mode, a cooling fan is mainly used for heat dissipation of a heat-producing component. A fan rotor for the cooling fan can increase the air circulation rate while rotating, thereby improving the heat exchange efficiency with air. During operation, the cooling fan can continuously conduct the heat generated during operation of the heat-producing components to ambient air, thereby implementing heat dissipation.

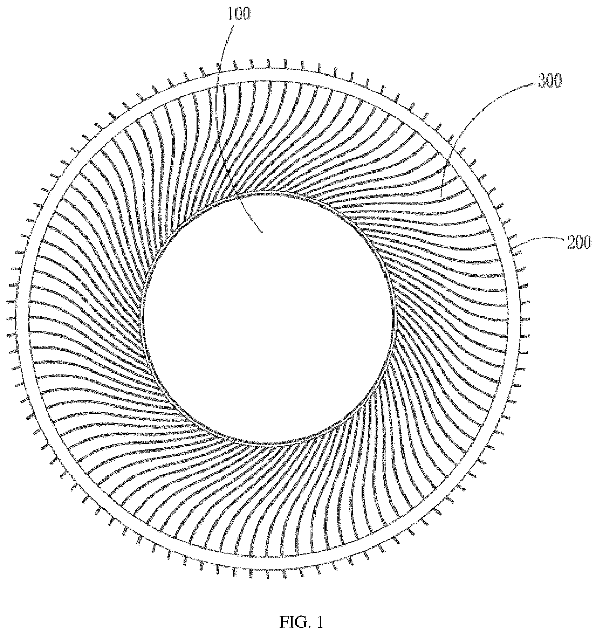

Current electronic devices mostly adopt centrifugal cooling fans as cooling fans therein. As shown in FIG. 1, a fan rotor for a centrifugal cooling fan is formed with a plurality of centrifugal blades 300 on a central shaft 100 and a fixing ring 200. Such a centrifugal cooling fan can conduct heat from a specific region to the outside in time, and therefore is widely applied to different electronic devices.

However, upon a high flow rate, the centrifugal cooling fan tends to have a low air pressure, and upon a high air pressure, the flow rate tends to be low. Due to relatively high system impedance and small air inlet space, the centrifugal cooling fan may cause significant flow loss in the system, thereby affecting the heat dissipation capability of the cooling fan.

To improve the heat dissipation capability of the cooling fan, some embodiments of the present application provide a cooling fan applicable to an electronic device such as a laptop, a personal computer (PC), or the like. The fan rotor for the cooling fan incorporates blades with rotor characteristics, thereby effectively solving the problems of high system impedance and low system flow rate under unsatisfactory air inlet conditions. Further, the performance bottleneck of the existing centrifugal cooling fans can be broken through, the overall heat dissipation capability and the use experience can be improved, and the overall system performance can be optimized.

The blades with the rotor characteristics can increase the flow rate and the air pressure of the cooling fan. In the fan rotor for a cooling fan according to some embodiments of the present application, blades with rotor characteristics are added on the basis of centrifugal blades. In this manner, the air inlet volume of the cooling fan can be increased while ensuring the sweeping capability, so that the performance of a single cooling fan can be effectively improved, and the backflow resistance capability of the cooling fan is enhanced, thereby reducing the loss of flow entering the system by the cooling fan. Meanwhile, given the same size, the rate of flow entering the system by the cooling fan is increased, which breaks through the performance bottleneck of conventional centrifugal cooling fans, and improves the heat dissipation capability of the cooling fan.

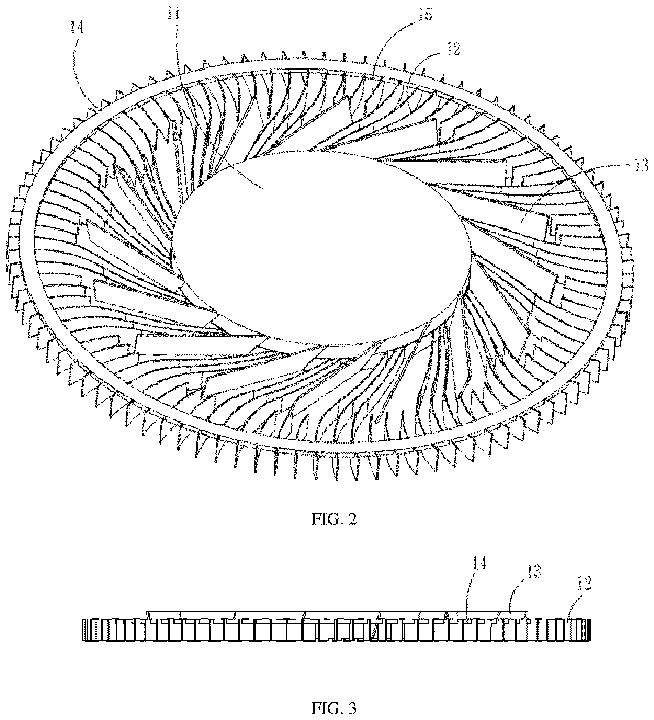

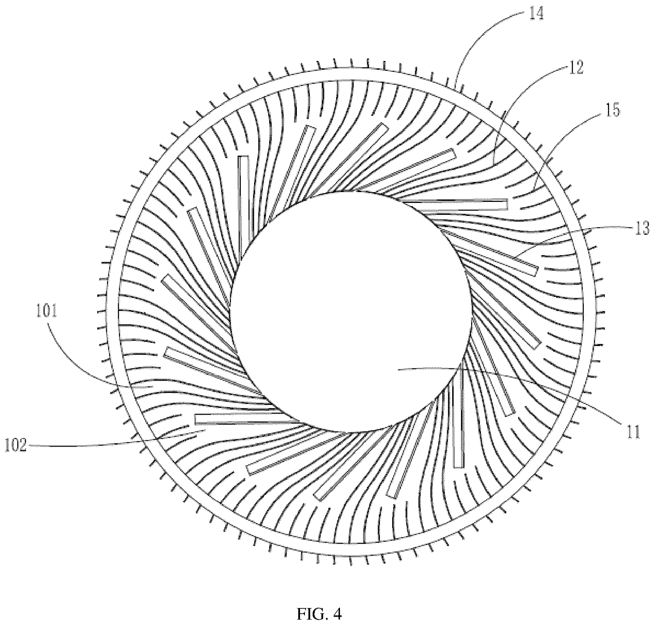

A fan rotor for a cooling fan according to some embodiments of the present application is explained below with reference to FIGs. 2 to 11.

As shown in FIGs. 2 to 7, a fan rotor according to some embodiments of the present application includes a central shaft 11, a plurality of first blades 12, a plurality of second blades 13, and a fixing ring 14. The central shaft 11 is provided with a first region 101 and a second region 102 alternately distributed along a circumferential direction at a periphery of the central shaft 11. The plurality of first blades 12 are arranged around the central shaft 11 in the first region 101, each having a first end connected to the central shaft 11. The plurality of second blades 13 are arranged around the central shaft 11 in the second region 102, each having a first end connected to the central shaft 11. The fixing ring 14 is arranged around the central shaft 11, and connected to a second end of each of the plurality of first blades 12.

The central shaft 11 is a part of the fan rotor for fixing the blades, and may also be referred to as a disc or hub of blades, or may form a motor case. The fan rotor is matched with the fan stator, and rotated relative to the fan stator when driven by a motor. During rotation with the central shaft 11, the blades may disturb the ambient air and form an air flow, thereby facilitating heat exchange of air.

The plurality of first blades 12 and the plurality of second blades 13 are both arranged around the central shaft 11. For example, the plurality of first blades 12 and the plurality of second blades 13 may be arranged around the same center. One of the first blade 12 or the second blade 13 plays a role of directional heat dissipation in the fan rotor, while the other has an air suction capacity.

For example, in some cases, the first blade 12 may be a centrifugal blade. A large number of first blades 12 are provided and generate a centrifugal force during rotation, thereby disturbing air to generate an airflow in a specific direction. Each first blade 12 extends from an edge of the central shaft 11 to the fixing ring 14 at the periphery of the central shaft 11. An edge of the first blade 12 may be terminated in the fixing ring 14. The edge of the first blade 12 may also extend partially beyond the fixing ring 14 to ensure the sweeping capability of the blade.

The second blade 13 may be an axial flow blade which has an air suction capacity and can increase the air inlet volume. In practice cases, in a direction around the central shaft 11, one side edge of the second blade 13 is closer to the first blade 12 than the other side edge, and has axial air suction characteristics of a rotor blade. The second blade 13, as a blade having an air suction capacity, can perform air suction in a reserved region left on one side of the first blade 12, so that air flows in an axial direction of the central shaft 11. The air inlet volume of the cooling fan can be effectively increased by the axial air suction capacity of the second blade 13.

It should be noted that in the embodiments of the present application, the case where the first blade 12 may be a centrifugal blade, and the second blade 13 may be an axial flow blade is taken as an example for illustration. In practice cases, it is also possible that the first blade 12 is an axial flow blade, and the second blade 13 is a centrifugal blade. In other words, the centrifugal blade and the axial flow blade may be selected and arranged in the first region 101 and the second region 102 according to the actual situation. The centrifugal blade and the axial flow blade may be designed to have the same in length or have different lengths. When the two types of blades have different lengths, the centrifugal blade may have a length greater than the axial flow blade, or the axial flow blade may have a length greater than the centrifugal blade. Each of the first blade 12 and the second blade 13 may follow a curve when extending from root to tip, so that the blades can be fully extended, and the air volume and air pressure can be increased.

In addition, in the embodiments of the present application, the shape and number of the axial flow blades are not limited, and any blade that can achieve the basic function of an axial flow blade is within the scope of the present application. Likewise, in the embodiments of the present application, the shape and number of the centrifugal blades are not limited, and any blade that can achieve the basic function of a centrifugal blade is within the scope of the present application.

The fixing ring 14 disposed at the periphery of the central shaft 11 can play a role of fixing at tips of the blades, so that the blades as a whole is kept stable during operation, and noise during operation of the blades is reduced. Therefore, the fixing ring 14 may also be referred to as a silencer ring. One or more fixing rings 14 may be provided and connected to the central shaft 11 via the first blades 12. It is also possible to further connect the second blades 13 to the central shaft 11 when the second blades 13 have substantially the same extension length as the first blades 12.

In the fan rotor according to some embodiments of the present application, the first blade 12 and the second blade 13 are both arranged in a hollowed-out region on one side of the blades. One of the first blade 12 or the second blade 13 has air suction characteristics, so that the air pressure, and thus the air inlet volume at the air inlet, can be increased. An air inlet region is reserved near the blades in the hollowed-out region on the one side of the blades, which can provide favorable conditions for air incoming from the air inlet of the cooling fan. With the blade having air suction characteristics incorporated in the hollowed-out region on the one side of the blades, an additional air suction effect is provided and the air pressure is increased on the basis of the air flow effect generated by the original blades. Therefore, the air inlet volume of the cooling fan is effectively increased, and the heat dissipation capability of the cooling fan is improved.

In some embodiments, the fan rotor may further include a plurality of third blades 15 arranged around the central shaft 11 in the second region 102. Each of the third blades 15 has a first end connected to the fixing ring 14, and a second end extending toward a corresponding second blade 13 in the same region.

The third blade 15 is of the same type as the first blade 12 or the second blade 13. In other words, the third blade 15 may be a centrifugal blade or an axial flow blade that is configured to improve the centrifugal effect or the air suction effect of the blades. The third blade 15 is connected to the fixing ring 14. The third blade 15 has a length smaller than the first blade 12. Compared with the first blade 12 having a relatively complete configuration, the third blade 15 occupies only a small portion at the periphery of the central shaft 11. In this case, the second blade 13 has a length smaller than the first blade 12, leaving a space at a periphery of the second blade 13. By arranging the third blade 15 in this part of space, an edge sweeping capability of the cooling fan can be ensured while ensuring a sufficient air inlet region. To improve the stability of the third blade 15, fixing rings 14 may be disposed at both ends of the third blade 15 for connection. In practice cases, the second end of the third blade 15 may be connected to the second blade 13.

When both the first blade 12 and the third blade 15 are arranged, a part of sweeping blades in a blade coverage region of the centrifugal cooling fan may be replaced with shorter blades, and the resulting vacancies are filled with the second blades 13. In this case, a gap is formed between the third blade 15 and the central shaft 11, forming a reserved region on a side of a thickness direction of the first blade 12, and a plurality of second blades 13 may be dispersed in a plurality of reserved regions. Each reserved region may include one or more second blades 13. The third blades 15 and the first blades 12 may be arranged alternately and regularly, or may be arranged randomly and irregularly.

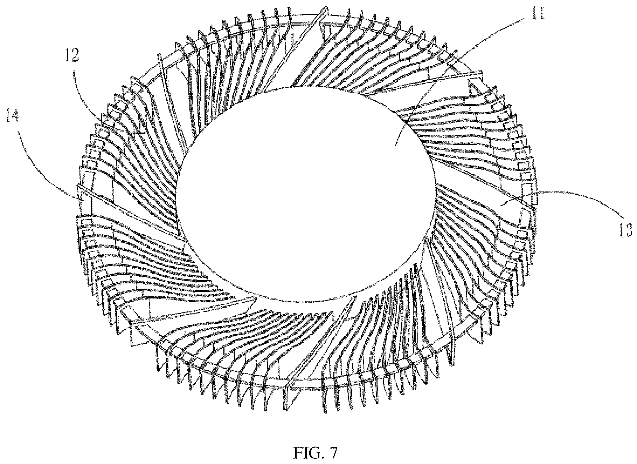

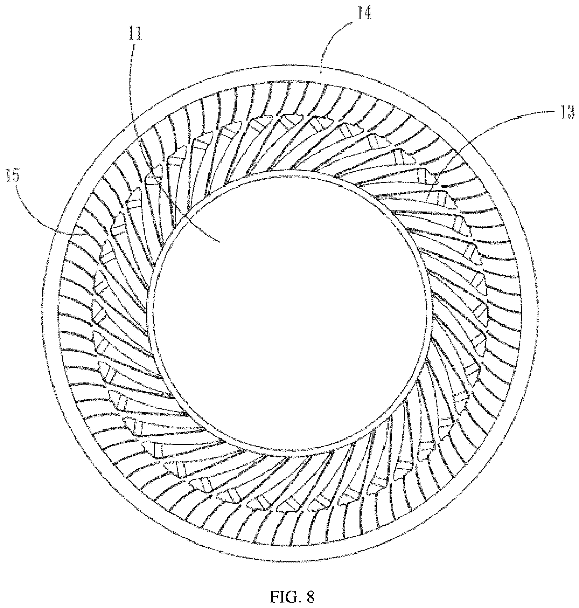

In practice cases, the first blade 12 and the third blade 15 may be combined with the second blade 13 together, to from the designs of the fan rotors as shown in FIGs. 2 to 6. Alternatively, the first blade 12 may be combined with the second blade 13, to form the design of the fan rotor as shown in FIG. 7. Alternatively, as shown in FIG. 8, the fan rotor may adopt a combined blade of the second blade 13 and the third blade 15, and some third blades 15 may be connected to adjacent second blades 13.

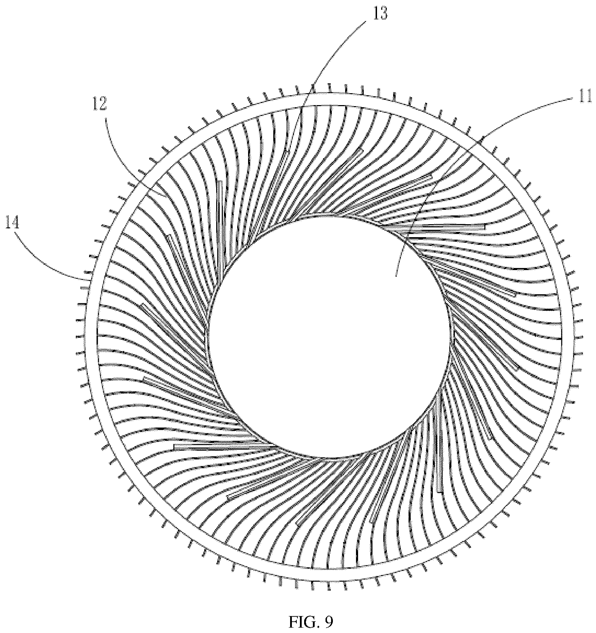

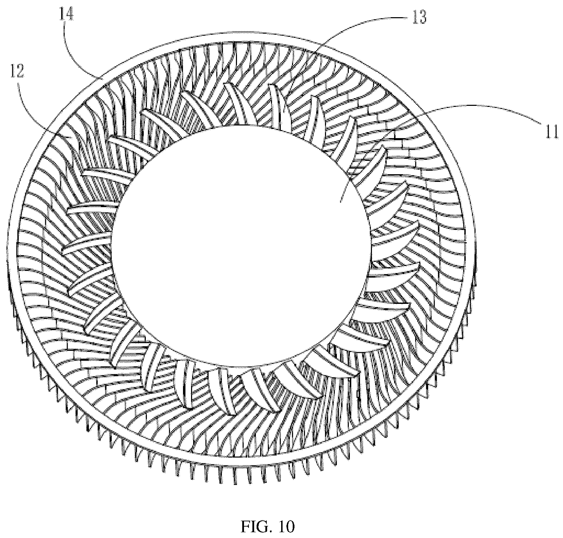

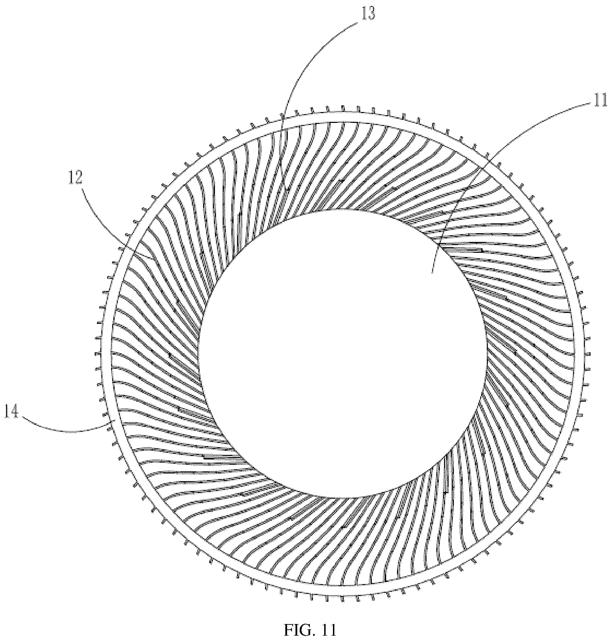

In addition, the two types of blades in the fan rotor may be arranged in different planes. As shown in FIG. 9, the fan rotor may adopt a combined blade of the first blade 12 and the second blade 13, and the two types of blades are arranged in different layers, and may be joined with each other. As shown in FIG. 10, in the layered arrangement, an inclination angle of the second blade 13 may be arranged at an obtuse angle with respect to an inclination angle of the first blade 12. Alternatively, the second blade 13 of the fan rotor may be directly molded onto the first blade 12 to form a combined blade as shown in FIG. 11. In practice cases, the second blade 13 may take many forms, including, but not limited to, straight-plate blades or curved blades of different sizes or different degrees of deformation as shown in FIGs. 2 to 11. The curved blades may adopt the form of a blade more curved at a root, or more curved at a tip, or curved to the same degree at the root and at the tip.

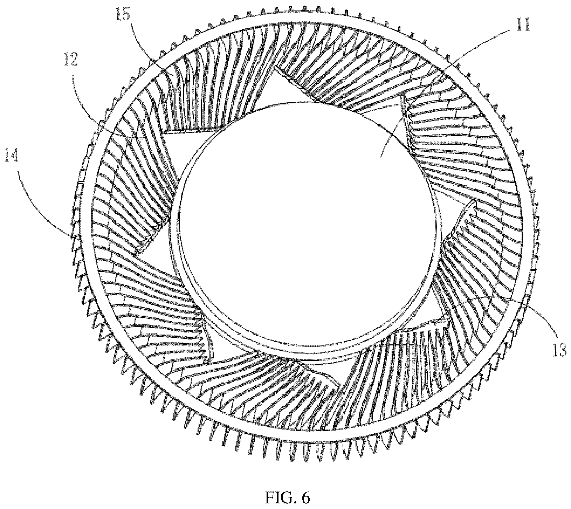

As shown in FIG. 6, in some embodiments, the plurality of second blades 13 may be arranged circularly in a direction opposite to the plurality of first blades 12.

The second blades 13 and the first blades 12 may be each arranged at a certain inclination angle. In other words, the blade may be arranged such that a blade tip and a blade root are not in the same radial direction of the central shaft 11. Specifically, the blade tip may be inclined toward one side, and the direction of inclination may be defined as a circular arrangement direction of the blade. In the case shown in FIG. 6, the tip of each first blade 12 is arranged inclined toward a following first blade 12 in a clockwise direction, which means that the first blades 12 are arranged circularly in the clockwise direction. An overall extending direction of the first blades 12 is at an acute angle with respect to a tangential direction of the central shaft 11, while the second blades 13 are arranged circularly in an opposite direction, with an overall extending direction at an obtuse angle with respect to the tangential direction.

By arranging the second blades 13 circularly in a direction opposite to the first blades 12, a sufficient air inlet region with no obvious blocking can be reserved without occupying too much arrangement space of the centrifugal blades, thereby increasing the air inlet volume of the cooling fan, and improving the heat dissipation performance of the cooling fan.

In some embodiments, more than one of the third blades 15 may be located in the same region, with lengths gradually increased or gradually decreased in the circumferential direction of the central shaft 11.

The third blades 15 with variable lengths can better adapt to the space left by the second blades 13 arranged inclined, so that the lengths of the third blades 15 can be fully extended, and the sweeping capability of the blades can be effective improved. As shown in FIG. 6, the lengths of the more than one third blades 15 in the same region may be gradually increased in a clockwise direction around the central shaft 11 to sufficiently extend on a side of the second blades 13 away from the central shaft 11, thereby increasing the effective area of the blades.

In addition, the second ends of the third blades 15 may be connected to the second blades 13 to improve the connection stability of the blades as a whole.

In practice cases, combinations of different numbers of first blades 12 and third blades 15 may be arranged at intervals. A plurality of first blades 12 arranged together can ensure the overall blade distribution density, and thereby ensure the sweeping capability of the blades as a whole. A plurality of third blades 15 arranged together can ensure a proper size of the reserved air inlet region, and provide a sufficient air inlet region without forming excessive blocking.

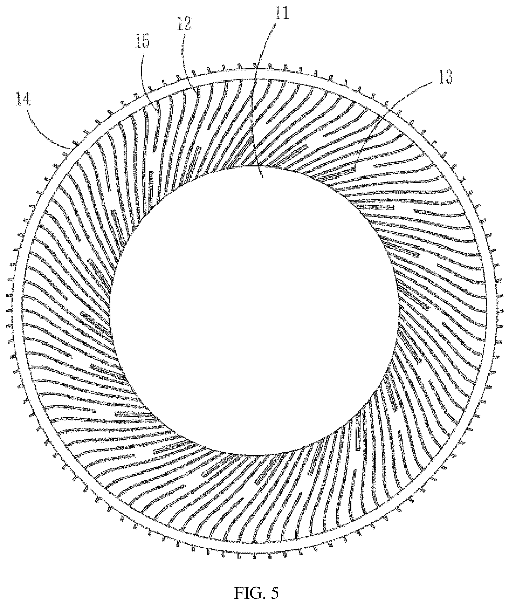

As shown in FIGs. 2 to 4, the first blades 12 and the third blades 15 may be distributed at intervals in groups of three, respectively. In other words, when viewed in a direction around a center of the central shaft 11, groups of three first blades 12 and groups of three third blades 15 are alternately arranged in sequence. In this manner, the sweeping capability of the blades as a whole can be ensured, while a sufficient air inlet region can be provided. The first blades 12 and the third blades 15 may also be arranged in the modes shown in FIGs. 5 and 6. As shown in FIG. 5, the first blades 12 are distributed at intervals in groups of four, and the third blades 15 are distributed at intervals in groups of one. As shown in FIG. 6, a plurality of first blades 12 and a plurality of third blades 15 are provided, and the lengths of the more than one third blades 15 in the same region are gradually changed with the shape of the corresponding second blade 13. In practice cases, the first blades 12 and the third blades 15 may also be arranged in other modes.

In some embodiments, the plurality of first blades 12 may be centrifugal blades, and the plurality of second blades 13 may be axial flow blades.

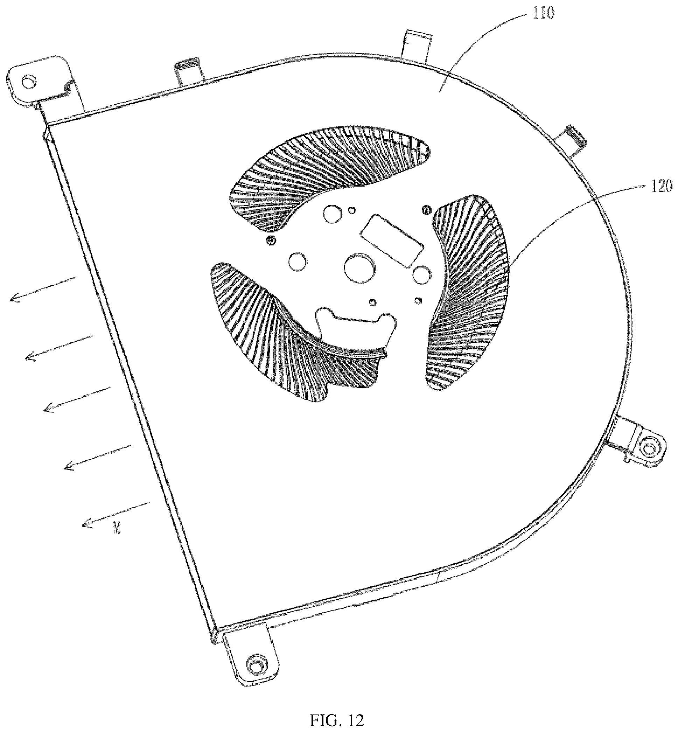

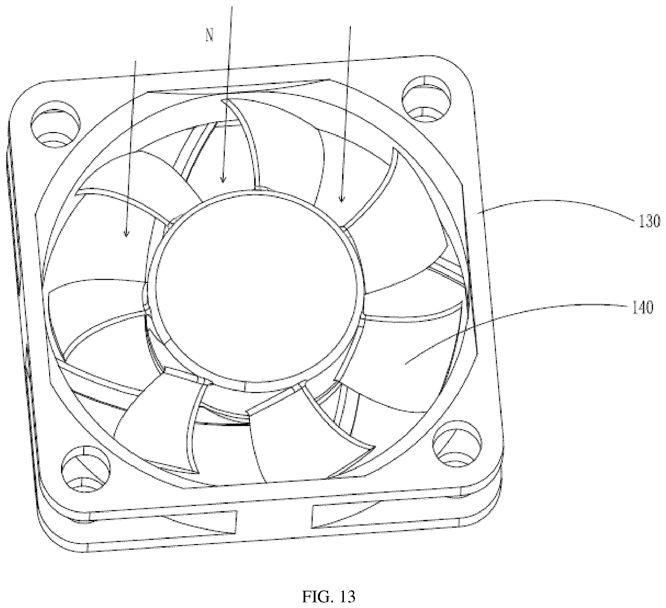

By arranging the centrifugal blades 120 used in the centrifugal fan 110 shown in FIG. 12 in the first region 101, and arranging the axial flow blades 140 used in the axial flow fan 130 shown in FIG. 13 in the second region 102, both types of blades can exhibit excellent performance. The centrifugal fan 110 may be provided with more centrifugal blades 120, which have a larger effective area in the radial direction and may be rotated to generate an air flow in a radial direction indicated by the arrow M in FIG. 12. The centrifugal blades 120 can play a better role in sweeping air. The axial flow blades 140 used in the axial flow fan 130 have an air suction capacity and can increase the air inlet volume. During rotation, the axial flow blades 140 generate an air flow in an axial direction indicated by the arrow N in FIG. 13. The axial flow blades 140 each have a forward or backward inclined shape and a larger effective area in the axial direction, and can generate an airflow in the axial direction during rotation. Generally, fewer axial flow blades 140 are provided, and a single axial flow blade 140 may take a large area when arranged.

In some embodiments, when the third blade 15 and the first blade 12 are of the same type, a plurality of third blades 15 and a plurality of first blades 12 may located in the same plane, and the plurality of third blades 15 and the plurality of first blades 12 may be distributed uniformly at the periphery of the central shaft 11.

In other words, the centrifugal blades, including the third blades 15 and the first blades 12, are arranged uniformly at the periphery of the central shaft 11 as a whole. In this manner, the centrifugal blades fully distributed at the periphery of the central shaft 11 can be ensured to uniformly play a role in sweeping air, so that the stability of the cooling fan in operation will not be affected by concentrated stress on the blades at some positions.

As shown in FIG. 7, when the second blade 13 has substantially the same length as the first blade 12, the second blade 13 may be also connected to the fixing ring 14. In other words, second ends of the plurality of second blades 13 extend to a position where the fixing ring 14 is located to be connected to the fixing ring 14.

With the second blades 13 fully extending, the effective area of the second blades 13 can be increased, thereby producing a better axial air suction effect. Further, with the plurality of second blades 13 connected to the fixing ring 14, the connection stability of the blades as a whole can be ensured, thereby ensuring stability of the cooling fan in operation.

In some embodiments, when the second blades 13 are axial flow blades, each second blade 13 may be disposed inclined in the same direction with respect to the corresponding first blade 12, or each second blade 13 may be curved in the same direction with respect to the corresponding first blade 12.

The inclined or curved second blades 13 can facilitate the axial air suction of the cooling fan. When the second blade 13 is inclined or curved with respect to the first blade 12, an air suction characteristic similar to that of a rotor blade may be formed, so that a pressure difference is formed on the second blade 13 across two sides of the central shaft 11, thereby increasing the air inlet volume.

In practice cases, the inclined blade can facilitate convenient manufacturing and molding, while the curved blade can enhance the air suction capacity. The inclined blade may be a straight-plate blade, which means that the blade has a planar shape as a whole, and is inclined with respect to the first blade 12 as a whole. The curved blade may adopt a curved blade with a bigger tip and a smaller root, or a curved blade with a smaller tip and a bigger root. In addition, the second blade 13 may be designed to have different degrees of curvature to adjust the air suction capacity.

In some embodiments, a projection of each second blade 13 toward an adjacent first blade 12 is located within edges of the first blade 12.

In other words, the second blade 13 has an overall size not exceeding the first blade 12, and may be disposed in the reserved region on one side of the first blade12. The second blade 13 has smaller length and width than the first blade 12, so that the projection of the second blade 13 toward the adjacent first blade 12 can be located within edges of the first blade 12. Further, there is no need to provide an extra space for arrangement of the second blade 13, which is beneficial to reducing the volume of the fan rotor.

In some embodiments, the plurality of second blades 13 and the plurality of first blades 12 may be distributed in different planes, and in an axial direction of the central shaft 11, each of the second blades 13 at least partially protrudes out of edges of the first blade 12.

The second blade 13 is arranged at an air inlet of the fan rotor, so that the second blade 13 may be distributed in a different plane from the first blade 12, and extend beyond edges of the first blade 12 at the air inlet side. Therefore, the effective area of the second blade 13 is increased to form an axial air flow in a larger region, thereby increasing the air inlet volume of the fan rotor.

In addition, the plurality of first blades 12 may be distributed uniformly at the periphery of the central shaft 11, and/or the plurality of second blades 13 may be distributed uniformly at the periphery of the central shaft 11.

The first blades 12 and the second blades 13 uniformly arranged can generate a uniform disturbance effect at the periphery of the central shaft 11 and relatively uniform stress on the blades, so that the operation process of the fan rotor is more stable.

In some embodiments, the plurality of first blades 12 and the plurality of second blades 13 may be integrally formed with the central shaft 11.

This can effectively improve the joint strength between the structures. Since the first blade 12 and the second blade 13 are blades of different shapes and sizes, connection failure of the blades may easily occur in the manufacturing process due to different manufacturing processes. With the first blade 12 and the second blade 13 combined by integrally forming, the connection strength of the combined blades can be ensured. In addition, the fixing ring 14 and the third blade 15 may also be integrally formed with the central shaft 11.

In some embodiments, the central shaft 11 may include a first central shaft and a second central shaft connected with each other. A first end of each first blade 12 is connected to the first central shaft 11, and a first end of each second blade 13 is connected to the second central shaft 11.

The two central shafts 11 may provide a fixed basis for the different blades. To form a fan rotor with combined blades, the two central shafts 11 may be fixedly connected so that the blades on the two central shafts 11 are combined. In this manner, the manufacturing and forming of the fan rotor can be facilitated, so that blades of complex shapes can be manufactured and formed, and the characteristics of the air suction blades can be fully exerted.

In practice cases, a collar may be used instead of the central shaft 11. The second blades 13 may be formed at a periphery of the collar. Then, the collar is matched with the central shaft 11 of the first blades 12 to form combined blades.

As shown in table I below, according to a simulation comparison, the cooling fan with combined blades has a significantly higher air suction capacity at the air inlet, and in actual proofing, the cooling fan with combined blades has a maximum static pressure higher than the conventional centrifugal cooling fan. From the simulation data, it can be seen that under a given rotating speed, the cooling fan with combined blades has a maximum air volume increased by about 16.2%. Therefore, in the cooling fan provided in some embodiments of the present application, the fan rotor with the combined blades can combine the characteristics of the centrifugal blade and the axial flow blade while having the advantages of high air volume and high air pressure.

**Table I. Simulation comparison data of centrifugal cooling fan and cooling fan with combined blades. In the table, RPM represents revolutions per minute; Q max refers to a maximum air volume, and cfm represents cubic feet per minute; and P max refers to a maximum static pressure value, and mmaq represents millimeter aqueous.**

| | Rotating speed/RPM | Q max/cfm | P max/mmaq |
|---|---|---|---|
| Centrifugal cooling fan | 4300 | 5.48 | 10.21 |
| Cooling fan with combined blades | | 6.37 | 10.29 |

In practice cases, the fan rotor may be made in various forms, for example, in an integrated mold-making mode, where conventional centrifugal blades are modified into a design of long and short blades, and blades with an air suction function are added at positions corresponding to the short blades. The integrated mold-making mode is low in cost, and the air suction blades may adopt inclined straight-plate blades or axial flow blades of simple shapes.

Alternatively, a separate mold-making and injection molding mode may be adopted, where blades are separately manufactured and then combined together by welding, bonding, or the like. Since the combined blades are formed through separate mold-making processes, the shape of the air suction blades can be made more complicated so that the characteristics of the axial flow fan blade can be fully exerted, and the overall performance of the combined blades can be greatly improved.

Some embodiments of the present application further provide a cooling fan, including a housing, a fan stator, and the fan rotor as described above. The fan stator is disposed in the housing, and the fan rotor is rotatably connected to the fan stator.

The cooling fan with the combined blades can greatly improve the performance without increasing the cost compared with the original design. By means of the characteristics of the air suction blades, the impedance resistance of the cooling fan can be improved, and the conversion rate of flow entering the system by the cooling fan can be increased. In addition, mold-making of the blade molds enables large-scale production, and allows to integrate the respective characteristics of the centrifugal blade and the rotator blade like an axial flow, thereby significantly improve the air volume and air pressure of the cooling fan. Further, by optimizing flow channels in the cooling fan, a small part of air flow can be guided into some regions with concentrated heat sources for heat dissipation, so that the heat dissipation capability and performance of the whole system are improved.

Some embodiments of the present application further provide an electronic device, including the cooling fan as described above.

The cooling fan may be used in the electronic device at a position corresponding to a component generating a large amount of heat. Based on the longitudinal air suction characteristic of the second blade, the air inlet volume at the air inlet of the cooling fan can be increased. Then by the combination of long and short blades in the first blades, the inlet air is more transversely compressed so that the air volume and air pressure at the air outlet can be effectively increased. Further, the second blade has strong suction toward one side, which can reduce the amount of air spilling out of the air inlet, and the air flow entering the system by the cooling fan has relatively high impedance resistance, so that a higher conversion efficiency can be obtained after air flow enters the system, and the system flow rate will also be increased. Therefore, the heat exchange efficiency of the system can be increased, and the heat radiation performance can be improved. Therefore, the problem of inadequate system air volume in an electronic device such as an ultrathin laptop is addressed, and the size of the cooling fan can be reduced while ensuring performance of the cooling fan, thereby reducing the occupied space area and the product weight, and improving the performance of the whole system and the feel of use under the same conditions.

It will be understood by those of ordinary skill in the art that the foregoing implementations are specific embodiments of the present application, and that, in practical applications, various changes in form and details may be made therein without departing from the spirit and scope of the present application.

## Claims

1. A fan rotor, comprising:
a central shaft provided with a first region and a second region alternately distributed along a circumferential direction at a periphery of the central shaft;
a plurality of first blades arranged around the central shaft in the first region, each having a first end connected to the central shaft;
a plurality of second blades arranged around the central shaft in the second region, each having a first end connected to the central shaft; and
a fixing ring arranged around the central shaft and connected to a second end of each of the plurality of first blades.

2. The fan rotor of claim 1, further comprising:
a plurality of third blades arranged around the central shaft in the second region, wherein each of the third blades has a first end connected to the fixing ring, and a second end extending toward a corresponding second blade in the same region.

3. The fan rotor of claim 2, wherein:
the plurality of second blades are arranged circularly in a direction opposite to the plurality of first blades.

4. The fan rotor of claim 3, wherein:
more than one of the third blades are located in the same region, with lengths gradually increased or gradually decreased in the circumferential direction of the central shaft.

5. The fan rotor of claim 1, wherein:
the plurality of first blades are centrifugal blades, and the plurality of second blades are axial flow blades.

6. The fan rotor of claim 1, wherein:
second ends of the plurality of second blades extend to a position where the fixing ring is located to be connected to the fixing ring.

7. The fan rotor of claim 1, wherein:
a projection of each second blade toward an adjacent first blade is located within edges of the first blade.

8. The fan rotor of claim 1, wherein:
in an axial direction of the central shaft, each of the second blades at least partially protrudes out of edges of the first blade.

9. A cooling fan, comprising:
a housing;
a fan stator in the housing; and
the fan rotor of any of claims 1 to 8, wherein the fan rotor is rotatably connected to the fan stator.

10. An electronic device, comprising the cooling fan of claim 9.
